# EUROPÄISCHE PATENTSCHRIFT

(11) **EP 1 919 083 B1**
(45) Veröffentlichungstag und Bekanntmachung des Hinweises auf die Patenterteilung: **20.06.2018**
(21) Anmeldenummer: 07119498.9
(22) Anmeldetag: 29.10.2007
(51) Int. Cl.: H03K 17/972, G06F 3/0362

(54) **Bedienvorrichtung**
Operating device
Dispositif de commande

(30) Priorität: 31.10.2006 DE 102006051920; 10.05.2007 DE 102007021903
(43) Veröffentlichungstag der Anmeldung: 07.05.2008
(73) Patentinhaber: Continental Automotive GmbH, 30165 Hannover (DE)
(72) Erfinder: Beilker, Dirk, 60598, Frankfurt (DE); Werner, Josef, 61389, Schmitten/Dorfweil (DE); Drazek, Alice, 61348 Bad Homburg (DE)

(56) Entgegenhaltungen:
- EP-A2- 1 493 988
- DE-A1- 10 349 937
- DE-A1- 19 938 888
- DE-A1-102004 001 909
- JP-A- 2004 226 124

## Beschreibung

Die Erfindung bezieht sich auf eine Bedienvorrichtung mit einer um eine Drehachse drehbaren Handhabe, mittels der eine ringförmige Dauermagnetanordnung um die Drehachse drehbar antreibbar ist, die eine erste zur Drehachse senkrechte Ebene aufweist, wobei mehrere Hallsensoren in einer zur ersten Ebene parallelen zweiten Ebene fest angeordnet sind, durch die Signale erzeugbar sind, die einer Auswerteeinheit zur Ermittlung der Drehposition der Handhabe zuleitbar sind, wobei die wenigstens drei Hallsensoren mit gleichem radialen Abstand zur Drehachse und in einem Winkelabstand zueinander im Bereich des Magnetfeldes des Dauermagnetrings angeordnet sind. Eine derartige Anordnung ist in Form eines Zündanlassschalters aus der DE 199 38 888 A1 bekannt. Zum Stand der Technik gehört auch ein Winkelsensor mit einer Magnetscheibe gemäß EP 1 493 988 A2.

Bei einer weiteren Bedienvorrichtung ist es bekannt mindestens zwei Dauermagnetringe zu verwenden, wobei der eine Dauermagnetring den anderen Dauermagnetring umschließt. Jeder Dauermagnetring ist radial umlaufend mit einer Vielzahl Magnetpolen ausgebildet, die Kreissegmente bilden.

Jedem Dauermagnetring ist ein Hallsensor zugeordnet, wobei die Hallsensoren digitale Signale erzeugen.

Ein solcher Aufbau ist aufwendig.

Aufgabe der Erfindung ist es daher eine Bedienvorrichtung der eingangs genannten Art zu schaffen, die einen einfachen Aufbau mit wenigen Bauteilen aufweist und einen geringen Bauraum benötigt.

Diese Aufgabe wird erfindungsgemäß durch eine Bedienvorrichtung mit den Merkmalen des Anspruchs 1 gelöst.

Von der Auswerteeinheit werden aus den von jedem Hallsensor erfassten Spannungen Bezugsvektoren und aus den Bezugsvektoren ein resultierender Summenvektor ermittelt, entsprechend dessen Winkelposition ein Positionssignal erzeugbar ist.

Dabei wird neben der Lösung der Aufgabe weiterhin eine hohe Lebensdauer erreicht, da mechanische Beanspruchungen der Bauteile durch eine galvanische Trennung vermieden werden.

Vorzugsweise sind die wenigstens drei Hallsensoren in einem gleichen Winkelabstand zueinander angeordnet. Dies muss aber nicht sein, da die Winkelposition der Hallsensoren bei der Berechnung des Summenvektors berücksichtigt wird.

Eine Vereinfachung der Leitungsverbindungen der Hallsensoren wird dadurch erreicht, dass die Hallsensoren auf einer Leiterplatte angeordnet sind, wobei auf der Leiterplatte auch eine Auswerteelektronik angeordnet sein kann, so dass sich ein kompakter Aufbau ergibt. Erfindungsgemäß ist die Handhabe rohrartig mit einem durchgehenden Zylinderraum ausgebildet und in dem Zylinderraum ist eine Anzeige- und/oder Betätigungseinheit angeordnet. So entsteht ein zusätzlich nutzbarer Platz in der Mitte der Bedienvorrichtung.

Diese Anzeige- und/oder Betätigungseinheit kann beispielsweise für Funktions- oder Suchbeleuchtung oder als Taster genutzt werden.

Der Montageaufwand wird besonders dadurch reduziert, dass die Anzeige- und/oder Betätigungseinheit auf der Leiterplatte fest angeordnet ist.

Das Positionssignal bestimmt dabei die von der Handhabe eingenommene Position.

Ist von der Auswerteeinheit ein Ausfall eines der Hallsensoren erfassbar und ein dem ausgefallenen Hallsensor zugeordneter fester insbesondere mittlerer Spannungswert zur Ermittlung des resultierenden Summenvektors verwendbar, so wird auf diese Weise eine drastische Verfälschung des Summenvektors vermieden. Das ermittelte Positionssignal ist dann zwar nicht ganz korrekt, würde sich aber sehr stark dem richtigen Wert annähern. Damit kann ein totaler Ausfall des Systems verhindert werden.

Auch durch Verwendung von einer höheren Anzahl als von drei Hallsensoren wie z. B. von 4, 5, 6 oder mehr Hallsensoren kann durch eine höhere Redundanz die Größe eines Fehlers verringert werden. Die Genauigkeit der berechneten Winkelposition erhöht sich mit der Anzahl der Hallsensoren.

Von der Auswerteeinheit kann der Betrag des Summenvektors ermittelbar und der Dauermagnetring aus einer Normalposition, in der der Betrag des Summenvektors ein niedrigerer Normalsummenvektorbetrag ist, in eine den Abstand zwischen Dauermagnetring und Hallsensoren verringernde Schaltposition, in der der Betrag des Summenvektors ein erhöhter Schaltsummenvektorbetrag ist, bewegbar sein, wobei bei Überschreitung eines bestimmten Betrages des Summenvektors ein Schaltsignal erzeugbar ist und wobei der bestimmte Betrag des Summenvektors zwischen dem Normalsummenvektorbetrag und dem Schaltsummenvektorbetrag liegt.

Da der Betrag des Summenvektors auch in hohem Maß gleichmäßig von der magnetischen Flussdichte beeinflusst wird, die bei sich verringerndem Abstand des Dauermagnetrings zu den Hallsensoren zunimmt, ist dies zur Erzeugung des Schaltsignals nutzbar und eine zusätzliche Tastfunktion der Bedienvorrichtung realisierbar. Die Bedienvorrichtung kann somit als Dreh/-Drücksteller arbeiten.

Zur Eindeutigkeit der Schaltsignalauslösung kann der bestimmte Betrag des Summenvektors eine Hysterese aufweisen.

Damit bei normaler Drehbetätigung der Handhabe der Dauermagnetring sicher in seiner Normalposition verbleibt, kann der Dauermagnetring entgegen einer Federkraft aus seiner Normalposition in seine Schaltposition bewegbar sein.

Die Handhabe und der Dauermagnetring sind vorzugsweise fest miteinander verbunden.

Ein Ausführungsbeispiel der Erfindung ist in der Zeichnung dargestellt und wird im Folgenden näher beschrieben. Es zeigen:
- Figur 1: eine Prinzipdarstellung eines ersten Ausführungsbeispiels einer Bedienvorrichtung
- Figur 2: eine Draufsicht auf einen Dauermagnetring der Bedienvorrichtung nach Figur 1 und
- Figur 3: eine Vektordarstellung der von den Hallsensoren der Bedienvorrichtung erfassten Spannungen
- Figur 4: eine Prinzipdarstellung eines zweiten Ausführungsbeispiels einer Bedienvorrichtung.

Die dargestellte Bedienvorrichtung weist eine Handhabe 1 auf, die um eine Drehachse 2 drehbar gelagert und manuell um die Drehachse 2 drehbar ist.

Über ein koaxiales Verbindungsstück 3 ist die Handhabe 1 drehfest mit einem innerhalb eines Gehäuses 4 angeordneten Dauermagnetring 5 verbunden, der eine zur Drehachse 2 sich radial erstreckende erste Ebene 6 aufweist.

In einem Abstand den Dauermagnetring 5 axial gegenüberliegend sind in einer sich radial zur Drehachse 2 erstreckenden zweiten Ebene 7 drei Hallsensoren 8, 8' und 8" auf einer Leiterplatte 9 fest angeordnet.

Die Hallsensoren 8, 8', und 8" weisen gleichen Abstand zur Drehachse 2 und gleichen Winkelabstand zueinander auf.

Der Dauermagnetring 5 besitzt eine diametrale Magnetisierung, in deren Magnetfeld sich die Hallsensoren 8, 8' und 8" befinden.

Durch das Magnetfeld des Dauermagnetrings 5 werden in den Hallsensoren 8, 8' und 8" sog. Hallspannungen erzeugt, die entsprechend der jeweiligen Winkelpositionen der Hallsensoren 8, 8' und 8" zum Dauermagnet 5 variieren.

Diese Hallspannungen werden als Hallspannungssignale über nicht dargestellte Leiterbahnen der Leiterplatte 9 einer Auswerteelektronik 10 zugeführt, die ebenfalls auf der Leiterplatte 9 angeordnet ist.

Von der Auswerteelektronik 10 werden aus den einzelnen Hallspannungssignalen jedes Hallsensors 8, 8' und 8" Bezugsvektoren 11, 11' und 11" ermittelt und aus den Bezugsvektoren 11, 11' und 11" ein Summenvektor 12 gebildet.

Die Richtung dieses Summenvektors gibt die Winkelposition der Handhabe 1 an.

Diese Bedienungsvorrichtung ist ein Absolutwertgeber. Dies bedeutet, dass er direkt nach einem Einschalten den absoluten Positionswert richtig zuweisen kann.

Sollten an allen drei Hallsensoren 8, 8' und 8" Störungen durch z. B. Temperaturdrift, Änderungen am Magnetfeld, Spannungsoffset oder elektromagnetische Störungen auftreten, so ändern sich die Beträge der Bezugsvektoren 11, 11' und 11" proportional. Der Winkel des Summenvektors 12 wird also von den Störungen nicht beeinflusst und ein fester Bezugspunkt wie z. B. die Drehachse 2 ist nicht erforderlich.

Eine derartige Bedienvorrichtung kann z.B. als Drehsteller für verschiedene elektrische oder elektronische Geräte benutzt werden, bei denen eine Drehbewegung der Handhabe in ein elektrisches Signal umgewandelt werden soll. Im Zusammenhang mit elektrischen Kraftfahrzeugkomponenten werden derartige Bedienvorrichtungen beispielsweise bei Klimabediengeräten zur Einstellung der gewünschten Innentemperatur oder einer Luftverteilung im Fahrzeug eingesetzt. Ein Einsatz der Bedieneinrichtung ist auch wahlweise als Absolutwertgerber oder Inkrementalgeber oder auch als Mischung von beidem möglich. Bei einem Einsatz in einem Kraftfahrzeug ist auch eine Anwendung als Lenkwinkelpositionsgeber, Radpositionsgeber oder als universelles Mensch-Maschine-Interaktions-Eingebeelement (MMI-Eingabeelement) denkbar.

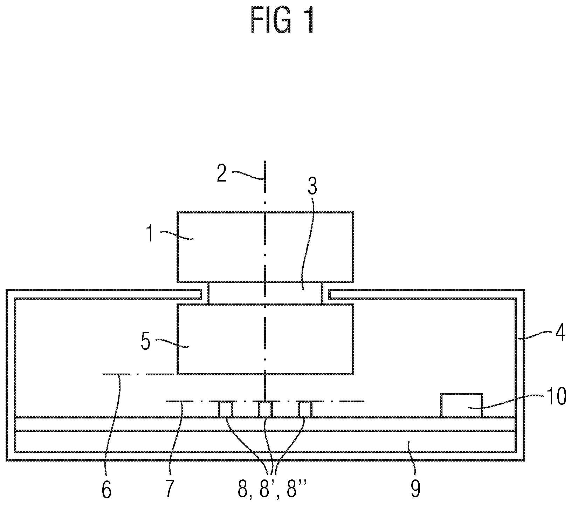

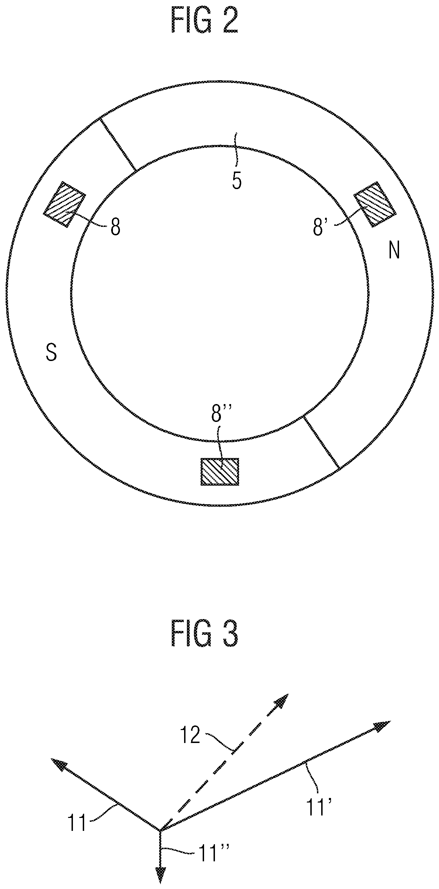

Das in Figur 4 dargestellte Ausführungsbeispiel der Bedienvorrichtung entspricht weitgehend dem in den Figuren 1 und 2 dargestellten Ausführungsbeispiel, wobei gleiche Teile mit gleichen Bezugszeichen versehen sind.

Im Unterschied zu dem Ausführungsbeispiel der Figuren 1 und 2 ist die Einheit aus Handhabe 1 und Dauermagnetring 5 aus einer angehobenen Normalposition in eine abgesenkte Schaltposition bewegbar. Dies erfolgt entgegen der Kraft einer Druckfeder 13, die mit ihrem einen Ende an der Leiterplatte 9 abgestützt ist und mit ihrem anderen Ende den Dauermagnetring 5 beaufschlagt. In Figur 4 ist neben der mit durchgezogener Linie dargestellten Normalposition des Dauermagneten 5 und dessen erster Ebene 6 mit unterbrochener Linie auch die Unterseite des Dauermagneten 5 und dessen erste Ebene 6' in der Schaltposition dargestellt.

In der Normalposition ist entsprechend dem Ausführungsbeispiel der Figuren 1 bis 3 die Winkelposition der Handhabe 1 erfassbar.

Erfolgt durch Drücken der Handhabe 1 ein Absenken in die Schaltposition, nimmt die von den Hallsensoren 8, 8' und 8" erfasste Flussdichte zu. Durch die Auswerteelektronik 10 wird aufgrund der Signale der Hallsensoren 8, 8' und 8" auch der Betrag des Summenvektors 12 ermittelt, der sich gegenüber der Normmalposition in der Schaltposition erhöht. Wird dabei ein bestimmter Betrag des Summenvektors 12 überschritten, erzeugt die Auswerteelektronik 10 ein Schaltsignal. Damit ist die Bedienvorrichtung als Dreh-/Drücksteller verwendbar.

## Patentansprüche

1. Bedienvorrichtung mit einer um eine Drehachse (2) drehbaren Handhabe (1), mittels der eine ringförmige Dauermagnetanordnung um die Drehachse (2) drehbar antreibbar ist, die eine erste zur Drehachse (2) senkrechte Ebene (6) aufweist, wobei wenigstens drei Hallsensoren (8, 8', 8") in einer zur ersten Ebene (6) parallelen zweiten Ebene (7) fest angeordnet sind, durch die Signale erzeugbar sind, die einer Auswerteeinheit (10) zur Ermittlung der Drehposition der Handhabe (1) zugeleitet werden, wobei die wenigstens drei Hallsensoren (8, 8', 8") mit gleichem radialen Abstand zur Drehachse (2) und in einem Winkelabstand zueinander im Bereich des Magnetfeldes der ringförmigen Dauermagnetanordnung angeordnet sind, wobei die Dauermagnetanordnung ein diametral magnetisierter Dauermagnetring (5) ist und die Auswerteeinheit (10) ausgebildet ist aus den von jedem Hallsensor (8, 8', 8") erfassten Spannungen Bezugsvektoren (11, 11', 11") und aus den Bezugsvektoren (11, 11', 11") einen resultierenden Summenvektor (12) zu ermitteln, entsprechend dessen Winkelposition ein Positionssignal erzeugbar ist, welches Positionssignal die von der Handhabe (1) eingenommene Position bestimmt, wobei die Handhabe (1) rohrartig mit einem durchgehenden Zylinderraum ausgebildet ist und in dem Zylinderraum eine Anzeige- und/oder Betätigungseinheit angeordnet ist, wobei die Hallsensoren (8, 8', 8") auf einer Leiterplatte (9) angeordnet sind und wobei die Anzeige- und/oder Betätigungseinheit auf der Leiterplatte (9) fest angeordnet ist.

2. Bedienvorrichtung nach Anspruch 1, **dadurch gekennzeichnet, dass** auf der Leiterplatte (9) eine Auswerteelektronik (10) angeordnet ist.

3. Bedienvorrichtung nach einem der vorhergehenden Ansprüche, **dadurch gekennzeichnet, dass** von der Auswerteeinheit (10) ein Ausfall eines der Hallsensoren (8, 8', 8") erfassbar und ein dem ausgefallenen Hallsensor (8, 8', 8") zugeordneter fester insbesondere mittlerer Spannungswert zur Ermittlung des resultierenden Summenvektors (12) verwendbar ist.

4. Bedienvorrichtung nach einem der vorhergehenden Ansprüche, **dadurch gekennzeichnet, dass** von der Auswerteeinheit (10) der Betrag des Summenvektors (12) ermittelbar und der Dauermagnetring (5) aus einer Normalposition, in der der Betrag des Summenvektors (12) ein niedrigerer Normalsummenvektorbetrag ist, in eine den Abstand zwischen Dauermagnetring (5) und Hallsensoren (8, 8', 8") verringernde Schaltposition, in der der Betrag des Summenvektors (12) ein erhöhter Schaltsummenvektorbetrag ist, bewegbar ist, wobei bei Überschreitung eines bestimmten Betrages des Summenvektors (12) ein Schaltsignal erzeugbar ist und wobei der bestimmte Betrag des Summenvektors (12) zwischen dem Normalsummenvektorbetrag und dem Schaltsummenvektorbetrag liegt.

5. Bedienvorrichtung nach Anspruch 4, **dadurch gekennzeichnet, dass** der bestimmte Betrag des Summenvektors (12) eine Hysterese aufweist.

6. Bedienvorrichtung nach einem der Ansprüche 4 oder 5, **dadurch gekennzeichnet, dass** der Dauermagnetring (5) entgegen einer Federkraft aus seiner Normalposition in seine Schaltposition bewegbar ist.

7. Bedienvorrichtung nach einem der Ansprüche 4 bis 6, **dadurch gekennzeichnet, dass** die Handhabe (1) und der Dauermagnetring (5) fest miteinander verbunden sind.

## Claims

1. Operating device having a handle (1) that can be rotated about an axis of rotation (2), by means of which an annular permanent magnet arrangement which has a first plane (6) perpendicular to the axis of rotation (2) can be rotatably driven about the axis of rotation (2), wherein at least three Hall sensors (8, 8', 8") are fixedly arranged in a second plane (7) parallel to the first plane (6), by means of which signals which are fed to an evaluation unit (10) for determining the rotational position of the handle (1) can be generated,
wherein the at least three Hall sensors (8, 8', 8") are arranged at the same radial distance from the axis of rotation (2) and at an angular distance from one another within the range of the magnetic field of the annular permanent magnet arrangement,
wherein the permanent magnet arrangement is a diametrically magnetized permanent magnet ring (5) and the evaluation unit (10) is designed to determine reference vectors (11, 11', 11") from the voltages detected by each Hall sensor (8, 8', 8") and, from the reference vectors (11, 11', 11"), to determine a resultant sum vector (12), corresponding to the angular position of which a position signal which determines the position assumed by the handle (1) can be generated, wherein the handle (1) is formed in the manner of a tube with a continuous cylindrical space and an indicating and/or actuating unit is arranged in the cylindrical space,
wherein the Hall sensors (8, 8', 8") are arranged on a circuit board (9), and wherein the indicating and/or actuating unit is/are fixedly arranged on the circuit board (9).

2. Operating device according to Claim 1, **characterized in that** evaluation electronics (10) are arranged on the circuit board (9) .

3. Operating device according to one of the preceding claims, **characterized in that** a failure of one of the Hall sensors (8, 8', 8") can be detected by the evaluation unit (10), and a fixed, in particular medium, voltage value assigned to the failed Hall sensor (8, 8', 8") can be used to determine the resultant sum vector (12).

4. Operating device according to one of the preceding claims, **characterized in that** the magnitude of the sum vector (12) can be determined by the evaluation unit (10), and the permanent magnet ring (5) is movable from a normal position, in which the magnitude of the sum vector (12) is a low normal sum vector magnitude, into a switching position reducing the distance between permanent magnet ring (5) and Hall sensors (8, 8', 8"), in which the magnitude of the sum vector (12) is an increased switching sum vector magnitude, wherein, if a specific magnitude of the sum vector (12) is exceeded, a switching signal can be generated, and wherein the specific magnitude of the sum vector (12) lies between the normal sum vector magnitude and the switching sum vector magnitude.

5. Operating device according to Claim 4, **characterized in that** the specific magnitude of the sum vector (12) exhibits hysteresis.

6. Operating device according to either of Claims 4 and 5, **characterized in that** the permanent magnet ring (5) is movable from its normal position into its switching position counter to a spring force.

7. Operating device according to one of Claims 4 to 6, **characterized in that** the handle (1) and the permanent magnet ring (5) are fixedly connected to each other.

## Revendications

1. Dispositif de commande comprenant une manette (1) rotative autour d'un axe de rotation (2), au moyen de laquelle un arrangement d'aimants permanents de forme annulaire peut être entraîné en rotation autour de l'axe de rotation (2), laquelle possède un premier plan vertical (6) perpendiculaire à l'axe de rotation (2), au moins trois capteurs à effet Hall (8, 8', 8") étant montés en positon fixe dans un deuxième plan (7) parallèle au premier plan (6), par lesquels peuvent être générés des signaux qui sont acheminés à une unité d'interprétation (10) en vue de déterminer la position de rotation de la manette (1),
les au moins trois capteurs à effet Hall (8, 8', 8") étant disposés avec un même écart radial par rapport à l'axe de rotation (2) et à un écart angulaire les uns par rapport aux autres dans la zone du champ magnétique de l'arrangement d'aimants permanents de forme annulaire,
l'arrangement d'aimants permanents étant un anneau magnétique permanent (5) magnétisé diamétralement et l'unité d'interprétation (10) étant configurée pour déterminer des vecteurs de référence (11, 11', 11') à partir des tensions détectées de chaque capteur à effet Hall (8, 8', 8") et, à partir des vecteurs de référence (11, 11', 11'), une somme vectorielle (12) résultante,
conformément à la position angulaire duquel peut être généré un signal de position, ledit signal de position définissant la position adoptée par la manette (1), la manette (1) étant réalisée sous la forme d'un tube avec un espace cylindrique traversant et une unité d'indication et/ou d'actionnement étant disposée dans l'espace cylindrique,
les capteurs à effet Hall (8, 8', 8") étant disposés sur un circuit imprimé (9) et l'unité d'indication et/ou d'actionnement étant montée à demeure sur le circuit imprimé (9) .

2. Dispositif de commande selon la revendication 1, **caractérisé en ce qu'**une électronique d'interprétation (10) est disposée sur le circuit imprimé (9).

3. Dispositif de commande selon l'une des revendications précédentes, **caractérisé en ce qu'**une panne des capteurs à effet Hall (8, 8', 8") peut être détectée par l'unité d'interprétation (10) et une valeur de tension fixe, notamment moyenne, associée au capteur à effet Hall (8, 8', 8") en panne peut être utilisée pour déterminer la somme vectorielle (12) résultante.

4. Dispositif de commande selon l'une des revendications précédentes, **caractérisé en ce que** la valeur de la somme vectorielle (12) peut être déterminée par l'unité d'interprétation (10) et l'anneau magnétique permanent (5) peut être déplacé depuis une position normale, dans laquelle la valeur de la somme vectorielle (12) est une valeur de somme vectorielle normale plus faible, dans une position de commutation réduisant l'écart entre l'anneau magnétique permanent (5) et les capteurs à effet Hall (8, 8', 8''), dans laquelle la valeur de la somme vectorielle (12) est une valeur de somme vectorielle de commutation accrue, un signal de commutation pouvant être généré en cas de dépassement d'une valeur définie de la somme vectorielle (12) et la valeur définie de la somme vectorielle (12) étant comprise entre la valeur de somme vectorielle normale et la valeur de somme vectorielle de commutation.

5. Dispositif de commande selon la revendication 4, **caractérisé en ce que** la valeur définie de la somme vectorielle (12) possède une hystérésis.

6. Dispositif de commande selon la revendication 4 ou 5, **caractérisé en ce que** l'anneau magnétique permanent (5) peut être déplacé de sa position normale à sa position de commutation en s'opposant à la force d'un ressort.

7. Dispositif de commande selon l'une des revendications 4 à 6, **caractérisé en ce que** la manette (1) et l'anneau magnétique permanent (5) sont reliés ensemble à demeure.
